# EUROPÄISCHE PATENTSCHRIFT

(11) **EP 3 782 175 B1**
(45) Veröffentlichungstag und Bekanntmachung des Hinweises auf die Patenterteilung: **15.06.2022**
(21) Anmeldenummer: 19720751.7
(22) Anmeldetag: 18.04.2019
(51) Int. Cl.: H01F 7/20

(54) **POLYEDERFÖRMIGE SPULENSYSTEME MIT GROSSEM HOMOGENITÄTSVOLUMEN UND GROSSEM ZUGANGSBEREICH**
POLYHEDRAL COIL SYSTEMS HAVING A LARGE HOMOGENEITY VOLUME AND LARGE ACCESS ZONE
SYSTÈMES DE BOBINES EN FORME DE POLYÈDRE AYANT UN GRAND VOLUME D'HOMOGÉNÉITÉ ET UNE GRANDE ZONE D'ACCÈS

(30) Priorität: 20.04.2018 DE 102018109505
(43) Veröffentlichungstag der Anmeldung: 24.02.2021
(73) Patentinhaber: STL Systems AG, 8274 Tägerwillen (CH)
(72) Erfinder: LUDWIG, Christoph, 78462 Konstanz (DE); LUDWIG, Stefan, 8500 Frauenfeld (CH); LUDWIG, Wolfgang, 8274 Tägerwilen (CH)
(74) Vertreter: Patent- und Rechtsanwälte Behrmann Wagner PartG mbB
(86) Internationale Anmeldenummer: PCT/EP2019/060056
(87) Internationale Veröffentlichungsnummer: WO 2019/202063

(56) Entgegenhaltungen:
- DE-A1-102005 034 839
- DE-C1- 4 125 733
- JP-A- S59 148 308

## Beschreibung

Die Erfindung betrifft ein Spulensystem zur Erzeugung eines homogenen Magnetfeldes, mit einer Spulenanordnung, die jeweils aus mindestens zwei Spulen besteht, deren jeweilige Windungen planparallel zueinander liegende, drehsymmetrische Flächen mit unterschiedlicher Größe und einer gemeinsamen, senkrecht auf den Flächen stehenden Drehachse als Spulenachse aufspannen, wobei mindestens eine dieser Spulen gegensinnig von einem Strom durchflossen ist.

Spulensysteme, die auf einer derartigen Spulenanordnung beruhen, ergeben durch Hinzufügen derselben ein Spulensystem, das sich zur Erzeugung homogener Magnetfelder eignet. Insbesondere wenn ihre Spulenachsen orthogonal zueinander liegen, sind diese Spulensysteme geeignet, homogene Felder in beliebigen Richtungen zu erzeugen. Ein Magnetfeld mit hoher Homogenität im Zentrum des Spulensystems ist hinsichtlich der Stärke und Richtung nahezu unveränderlich und fällt außerhalb des Systems schnell ab. Bei geeigneter Auslegung des Spulensystems kann somit eine vernachlässigbare magnetische Fernfeldsignatur erzeugt werden, die sich z.B. so darstellen kann, dass das Magnetfeld außerhalb des Spulensystems bereits im Abstand von drei Systemgrößen um mehrere Größenordnungen abgefallen ist, was z.B. zur Einhaltung magnetischer Grenzwerte wichtig sein kann. In reziproker Anwendung als Messspule eingesetzt zeichnen sich diese Spulensysteme dadurch aus, dass sie Störfelder naheliegender Quellen sehr effizient unterdrücken können.

Einsatzbereiche sind beispielsweise industrielle Anwendungen wie die Kalibrierung von Magnetfeldsensoren, Kompensation magnetischer Störfelder, Neutralisierung magnetischer Signaturen, Test- und Qualitätskontrollen von Permanentmagneten sowie Verwendungen in der Materialforschung oder in der Medizintechnik, z.B. Kernspintomographie.

Als symmetrische Spulenanordnung zur Erzeugung eines homogenen Magnetfeldes ist die Helmholtz-Spule bekannt, bei der zwei gleichgroße Kreisspulen mit dem Radius R in dem definierten Abstand R auf einer gemeinsamen Achse planparallel angeordnet und gleichsinnig vom Strom durchflossen werden.

Um den Homogenitätsgrad des erzeugten Magnetfeldes im Zentrum der Spulenanordnung zu erhöhen und/oder die Fernfeldsignatur zu reduzieren bzw. Störfelder naheliegender Quellen effizienter unterdrücken zu können, sind als Stand der Technik verschiedene Wege eingeschlagen worden.

So zeigt die Offenlegungsschrift DE 10 2005 034 839 A1 eine Sende- und Empfangsspulenanordnung zur Erzeugung eines homogenen elektromagnetischen Wechselfeldes für die Anwendung in der NMR-Spektroskopie. Dabei sind mehrere Spulenpaare vorgesehen, deren jeweilige Spulen symmetrisch auf einer gemeinsamen Zylinderachse angeordnet sind und paarweise unterschiedliche Spulenquerschnitte aufweisen.

Die japanische Offenlegungsschrift JP S59 148308 A beschreibt ebenfalls ein symmetrisches Spulensystem zur Erzeugung eines homogenen Magnetfeldes, wobei die Spulen in Abhängigkeit des Abstands von der Symmetrieebene einen veränderlichen Spulendurchmesser aufweisen.

Die Patentschrift DE 41 25 733 C1 offenbart eine Vorrichtung zum Bestimmen von lokalen Magnetfeldverteilungen, wobei als Messgeräte planare Gradiometer auf mindestens drei nicht parallelen und nicht orthogonalen Flächen angeordnet sind.

In Erweiterung der Helmholtz-Spule ist in der Offenlegungsschrift EP 2487500 A1 ein symmetrisches Spulensystem offenbart, das in linearer Anordnung zwei Helmholtz-Spulenpaare mit Spulen gleichen Durchmessers zeigt. Die beiden Spulenpaare werden dabei gleichsinnig vom Strom durchflossen. Um die Gleichförmigkeit des Magnetfeldes weiter zu steigern, ist auch bekannt, Spulenpaare mit Spulen unterschiedlichen Durchmessers und gegensinnigem Stromfluss zu verwenden. Weiterhin sind Spulenanordnungen bekannt, die aus mehr als zwei Spulen mit gleichsinnigem Stromdurchfluss und unterschiedlichen Radien bestehen, z.B. Braunbek-Spulen (4 Spulen pro Achse) oder Maxwell-Spulen (3 Spulen pro Achse, davon eine im Spulenzentrum).

Darüber hinaus existieren komplexe Spulensysteme in mehrdimensionaler Anordnung wie triaxial ineinander verschachtelte Helmholtz-Spulen oder Braunbek-Spulen, um die Homogenität des Magnetfeldes bei gleicher Baugrösse zu erhöhen.

Ein Nachteil der auf einer Helmholtz-Anordnung beruhenden Spulensysteme besteht darin, dass der Experimentierraum im Zentrum einer derartigen Anordnung, also der nutzbare Raum, in dem das Magnetfeld weitgehend homogen ist, im Vergleich zu den Abmessungen des gesamten Spulensystems relativ klein ist. Um einen hinreichend großen Experimentierraum mit entsprechender Beschickungsöffnung bzw. Zugangsbereich zu erhalten, müssen daher ggf. sehr große Spulen verwendet werden. So erstreckt sich beispielsweise bei einem einfachen Helmholtz-Spulenpaar mit einem Spulenradius von einem Meter der nutzbare Raum, in dem das Magnetfeld nahezu unveränderlich ist, nur über ± 0.2m. Bei Spulenanordnungen mit höherem Homogenitäts-zu-Spulengrösse-Verhältnis reduziert sich der Zugangsbereich erheblich, so dass große Spulensysteme ausgewählt werden müssen, nur um den Zugang zum Experimentiervolumen zu gewährleisten.

Insbesondere bei den auf der Helmholtz-Spule beruhenden Weiterentwicklungen kann zwar die Homogenität des Magnetfeldes gesteigert werden, mitunter werden auch Designvorschriften angegeben, um einen spezifizierten Experimentierraum gewünschter Größe zu erhalten. Unbefriedigend aber bleiben die im Verhältnis zu dem bereitgestellten nutzbaren Experimentierraum erforderlichen großen Spulenabmessungen, die infolge komplexer Spulengeometrien eingeschränkte Zugänglichkeit des Experimentierraums und insbesondere die Tatsache, dass bei einem 3D System für jede Achse unterschiedliche Spulengeometrien mit den resultierenden Spulenparametern auftreten.

Der vorliegenden Erfindung liegt somit die Aufgabe zugrunde ein Spulensystem zu schaffen, das ein homogenes Magnetfeld erzeugt, wobei sich dieses Magnetfeld im Verhältnis zur Spulensystemgrösse über einen möglichst großen Raumbereich erstrecken soll, das auch bei großer Homogenität einen großen Zugangsbereich des Experimentierbereichs sicher stellt, das aus baugleichen Spulenanordnungen besteht und das für jede Spulenachse gleiche Spulenparameter liefert.

Diese Aufgabe wird in Verbindung mit den Merkmalen des Oberbegriffs des Anspruchs 1 dadurch gelöst, dass das Spulensystem aus mindestens drei Spulenanordnungen besteht, wobei die Spulen der jeweiligen Spulenanordnung sich innerhalb und planparallel ausgerichtet zur Grundfläche einer erzeugenden Pyramide befinden, deren Spitze mit dem Zentrum eines regelmäßigen, konvexen Polyeders zusammenfällt und deren Grundfläche mit einer solchen Fläche des konvexen Polyeders identisch ist, bei der die Projektion der Pyramidenspitze auf die Pyramidengrundfläche mit dem Mittelpunkt der Pyramidengrundfläche zusammenfällt, wobei der n-flächige Polyeder ein Tetraeder, ein Hexaeder, ein Oktaeder, ein Dodekaeder oder ein Ikosaeder ist, welcher aus n erzeugenden Pyramiden volumenausfüllend zusammensetzbar ist.

Die erzeugende Pyramide wird aus einer Polyederfläche als Grundfläche und dem Polyederzentrum als Pyramidenspitze gebildet. Ein Polyeder mit n Flächen setzt sich aus n erzeugenden Pyramiden zusammen und ist ein Tetraeder (Dreieckpyramide), ein Hexaeder (Quader oder Würfel), ein Oktaeder, Dodekaeder oder Ikosaeder.

Im bevorzugten Falle eines Würfels der Kantenlänge a besitzt die erzeugende Pyramide Öffnungswinkel von 90°, eine quadratische Grundfläche der Kantenlänge a und eine Höhe 0.5*a. Im Falle eines Tetraeders der Kantenlänge a besitzt die erzeugende Pyramide einen Öffnungswinkel von 109.5°, ein gleichseitiges Dreieck der Kantenlänge a als Grundfläche und eine Höhe.

Der Grundgedanke der vorliegenden Erfindung beruht somit darauf, eine Spulenanordnung für ein Spulensystem zur Erzeugung eines homogenen Magnetfeldes bereitzustellen, wobei sich das Spulensystem aus einer Mehrzahl dieser Spulenanordnungen zusammensetzen lässt. Vorzugsweise ist die Lage und Ausrichtung der einzelnen Spulenanordnungen in dem Spulensystem an den Flächen eines regelmäßigen geometrischen Körpers, z.B. an einem regelmäßigen, konvexen Polyeder mit n Flächen orientiert, der bevorzugterweise mit n=6 einem Würfel entspricht.

Ausgangspunkt ist die mit den Merkmalen des Oberbegriffs beanspruchte Spulenanordnung, die eine aus dem Stand der Technik bekannte planparallele und koaxiale Anordnung der Spulen-Querschnittsflächen beschreibt. Erfindungsgemäß besteht nun das Spulensystem aus mindestens zwei dieser Spulenanordnungen, wobei sich die Spulen der jeweiligen Spulenanordnung innerhalb der erzeugenden Pyramide mit den beschriebenen geometrischen Voraussetzungen befinden.

Eine Anzahl von vier Spulenanordnungen ergibt sich bei der Ausführung des regelmäßigen, konvexen Polyeders als Tetraeder, der vier gleichseitige Dreiecke als Flächen und damit vier Dreieckpyramiden als erzeugende Pyramiden besitzt. Bei einer Ausführung des regelmäßigen, konvexen Polyeders als Würfel gelangen dementsprechend zwei bzw. sechs erzeugende Pyramiden mit quadratischer Grundfläche zur Anwendung, die jeweils eine Spulenanordnung umfassen, je nachdem, ob das Magnetfeld in einer bzw. drei Raumrichtungen erzeugt oder gemessen werden soll.

Als Flächen des regelmäßigen, konvexen Polyeders kommen nur solche Flächen in Betracht, bei der die Projektion der Pyramidenspitze einer auf dieser Fläche errichteten erzeugenden Pyramide auf die Pyramidengrundfläche mit dem Mittelpunkt dieser Grundfläche zusammenfällt, der Fußpunkt des Lotes von der Pyramidenspitze also auf den Mittelpunkt der Pyramidengrundfläche abgebildet wird.

Die Windungen einer Spule spannen dabei eine drehsymmetrische (Spulen- Querschnitts-)Fläche auf, die im Falle einer kreisförmigen Spulengeometrie eine Kreisfläche ist (Rotationssymmetrie).

Im Fall einer Windungsführung entlang eines vorzugsweise regelmäßigen Polygonzuges ergibt sich ein regelmäßiges Polygon als Spulen-Querschnittsfläche (diskrete Drehsymmetrie), welche bei einer rechteckförmigen Spulengeometrie mit gleichen Kantenlängen in eine quadratische Fläche übergeht.

Die Spulen können hinsichtlich der Windungsführung durchaus verschiedene Formen annehmen, also beliebige drehsymmetrische Flächen aufspannen und auch in Achsenrichtung variieren, solange der Flächenvektor der Spule parallel zur Spulensystemachse bleibt. Beispielsweise kann eine kreisförmige Spule neben einer kleineren Spule quadratischen Querschnitts und einer Dreieckspule angeordnet sein. Mindestens eine der beteiligten Spulen wird dabei gegensinnig von Strömen durchflossen.

Die einzelnen Spulen sind hinsichtlich ihrer radialen Ausdehnung erfindungsgemäß so dimensioniert, dass sie, koaxial entlang einer Spulenachse positioniert, innerhalb einer gedachten Pyramide angeordnet werden können, welche die erzeugende Pyramide des Polyeders ist. Die Außenfläche dieser Pyramide bildet somit die geometrische Randbedingung für die Dimensionierung der äußeren Spulenabmessungen, wobei allerdings die näher an der Pyramidenspitze angeordneten Spulen zwar in der Regel, aber nicht zwingend eine kleinere Fläche aufspannen als weiter von der Pyramidenspitze entfernt liegende.

Auch können Spulen mit unterschiedlicher Querschnitts-Flächengröße und -Flächenform in einer Ebene liegend (koplanar) angeordnet sein.

Die entscheidende und erfindungsgemäße Bedingung ist, dass sämtliche Spulen mit ihren im Mittel planparallel und koaxial ausgerichteten Querschnittsflächen innerhalb einer den regelmäßigen, konvexen Systempolyeder erzeugenden Pyramide positionierbar sind.

Dabei fällt die Spitze einer jeden erzeugenden Pyramide mit dem Zentrum des Polyeders zusammen und die Pyramidengrundfläche ist mit einer solchen Fläche des Polyeders identisch, bei der die Projektion der Pyramidenspitze auf die Pyramidengrundfläche mit dem Mittelpunkt der Pyramidengrundfläche zusammenfällt.

Durch diese geometrische Randbedingung für die äußeren Spulenabmessungen einer jeden Spule ist es möglich, eine Mehrzahl von Spulenanordnungen in einem dreidimensionalen Raum auf den Flächen eines Polyeders innerhalb von (erzeugenden) Pyramiden mit nach innen weisenden Pyramidenspitzen anzuordnen, ohne dass es zu körperlichen Überschneidungen der Spulen kommt.

Grundsätzlich ist der die (Spulen-Querschnitts-)Fläche aufspannende Windungsverlauf beliebig.

Bevorzugt ist jedoch eine Kombination aus Polygon-Flächensegmenten und Kreis-Flächensegmenten. Diese ergibt sich beispielsweise bei Dreieckspulen oder quadratischen Spulen mit gerundeten Ecken.
Auch kann die von den jeweiligen Windungen der Spulen (S1, S2, S3) aufgespannte drehsymmetrische Fläche spiralförmig ausgebildet sein.
In weiterer Ausgestaltung weist ein Windungsverlauf einer der Windungen abschnittsweise eine Komponente in Richtung der Drehachse auf.
So kann die aufgespannte (Spulen-, Querschnitts-)Fläche als bogenförmige Fläche ausgeformt sein, deren Flächenvektor in integraler Betrachtung über die Fläche aber parallel zur Drehachse verläuft.

Die Positionierung der Spulenanordnungen innerhalb der erzeugenden Pyramiden, welche zusammengesetzt die äußere Form dieser geometrischen Körper mit hohen Symmetrieeigenschaften bilden erlaubt die Erzeugung homogener Magnetfelder mit hoher Störresistenz und stellt gleichzeitig einen großen Experimentierraum bereit. Die erforderlichen Spulendimensionen zur Bereitstellung eines bestimmten Experimentiervolumens können damit verringert werden, was in vorteilhafter Weise zu deutlich geringeren Herstellungs- und Betriebskosten führt.

Mit Vorteil werden die erfindungsgemäßen Spulensysteme in einem System eingesetzt zur Kalibrierung von Magnetfeldsensoren und Magnetkompassen, zur Erzeugung und Simulation magnetischer Randbedingungen an Satelliten und Raumsonden, zur Kompensation magnetischer Felder, zur Reduktion bzw. Neutralisierung magnetischer Signaturen an Schiffskomponenten, zu Tests und Qualitätskontrollen an Permanentmagneten, zur Vermessung magnetischer Eigenschaften in der Materialforschung und Geophysik und zur Erzeugung von Magnetfeldern und Magnetfeldgradienten in der Medizintechnik und Kernspintomographie.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- Fig. 1:: aus dem Stand der Technik ineinander verschachtelte Spulenanordnungen,
- Fig. 2:: eine schematische Ansicht einer erfindungsgemäßen Spulenanordnung mit drei Spulen,
- Fig. 3:: eine schematische, räumliche Darstellung eines eindimensionalen symmetrischen Spulensystems,
- Fig. 4:: eine schematische, räumliche Darstellung eines dreidimensionalen symmetrischen Spulensystems in Würfelanordnung,
- Fig. 5:: eine schematische, räumliche Darstellung eines dreidimensionalen symmetrischen Spulensystems in Tetraederanordnung,
- Fig. 6:: ein Modell eines weiteren dreidimensionalen, symmetrischen Spulensystems.

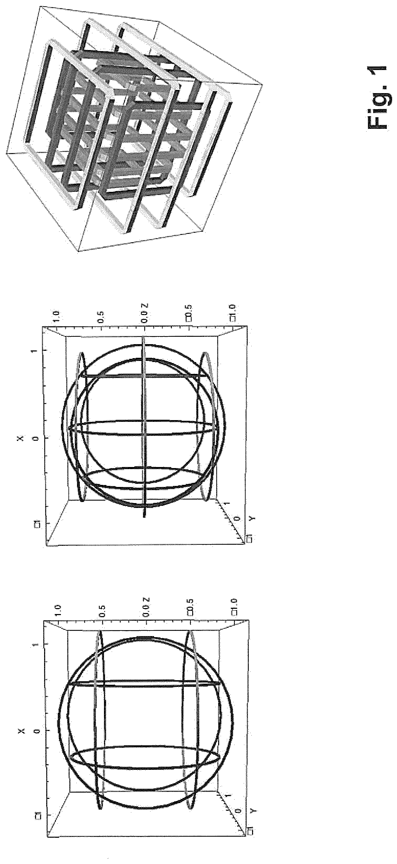

In Fig. 1 sind Beispiele für ineinander verschachtelte Spulenanordnungen zur Erzeugung eines dreidimensionalen Magnetfeldes dargestellt. Die linke Darstellung zeigt triaxial ineinander verschachtelte Helmholtz-Spulen, die mittlere Darstellung ein Maxwell-Spulensystem mit drei Spulen pro Achse und die rechte Darstellung ein Braunbek-Spulensystem mit vier Spulen pro Achse. In allen drei Darstellungen liegen die Spulenachsen orthogonal zueinander.

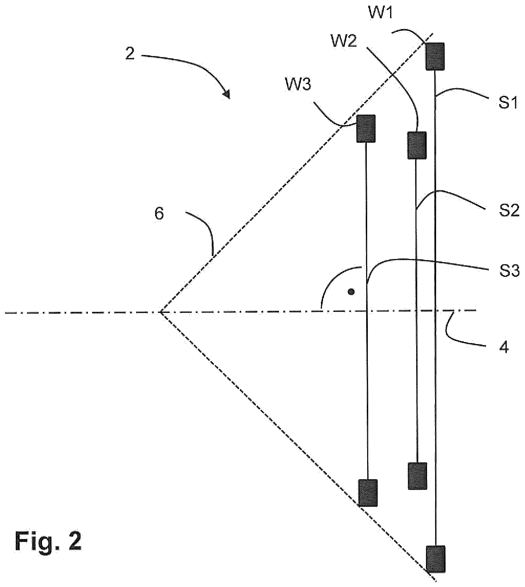

In Fig. 2 ist eine schematische Ansicht einer erfindungsgemäßen Spulenanordnung 2 mit drei Spulen S1, S2, S3 dargestellt. Die Spulen S1, S2, S3 sind so angeordnet, dass die von ihren jeweiligen Windungen W1, W2, W3 aufgespannten Flächen planparallel zueinander liegen und eine gemeinsame, senkrecht auf den Flächen stehenden Drehachse als Spulenachse 4 aufweisen.

Erfindungsgemäß sind die Spulen S1, S2, S3 so dimensioniert, dass sie mit ihren äußeren Abmessungen innerhalb einer erzeugenden Pyramide mit einer Mantellinie 6 - hier in Projektion dargestellt - positionierbar sind.

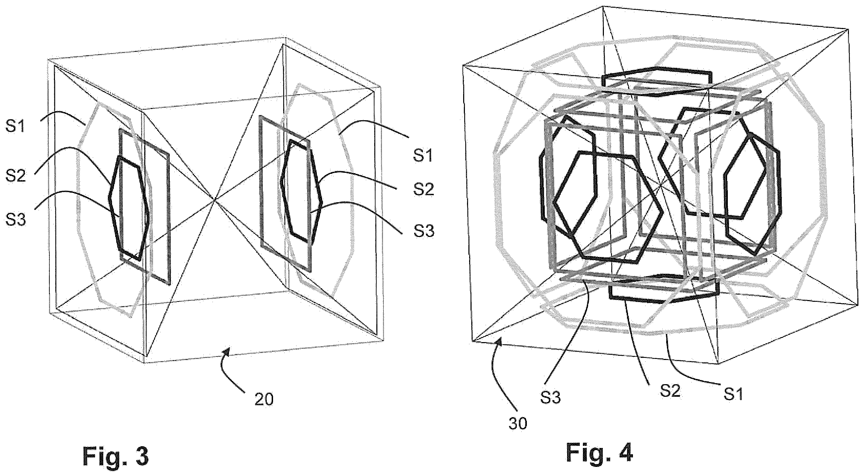

Fig. 3 zeigt eine schematische, räumliche Darstellung eines eindimensionalen symmetrischen Spulensystems 20, bei dem zwei Spulenanordnungen 2 aus Fig. 1 als Basisanordnung spiegelsymmetrisch so angeordnet sind, dass deren Spulenachsen 4 (Fig. 2) auf einer gemeinsamen Geraden liegen, wobei die Pyramidenspitzen der Pyramiden aufeinander zeigen und mit dem Zentrum eines als Würfel ausgebildeten Polyeders zusammenfallen.

In Erweiterung eines eindimensionalen symmetrischen Spulensystems ist in Fig. 4 eine schematische, räumliche Darstellung eines erfindungsgemäßen dreidimensionalen symmetrischen Spulensystems 30 in Würfelanordnung gezeigt. Entsprechend der Anzahl der Seiten des konvexen Polyeders als Würfel ist dieses Spulensystem 30 aus sechs erfindungsgemäßen Spulenanordnungen zusammengesetzt.

Aus dieser Darstellung wird deutlich, dass die erfindungsgemäße geometrische Randbedingung, die Spulen innerhalb einer Mantelfläche einer erzeugenden Pyramide mit dem Öffnungswinkel von 90° anzuordnen, erfüllt sein muss, um eine beliebige Anzahl von Spulen überschneidungsfrei in äußerer Form eines Würfels anordnen zu können.

Die würfelförmige Anordnung kann durch sechs solcher erzeugenden Pyramiden aufgebaut werden, wobei die Grundfläche dieser Pyramide einer Seitenfläche des Würfels entspricht.

Eine derartige orthogonale triaxiale Anordnung auf der Basis von drei identischen Helmholtz-Spulenpaaren zu errichten, ist nicht möglich, da sich aufgrund des bei der Helmholtz-Anordnung festgelegten Verhältnisses von Spulengröße zu Spulenabstand die Spulen durchdringen würden. Daher sind aus dem Stand der Technik die oben genannten ineinander verschachtelten Spulenpaare, also Spulenpaare mit unterschiedlicher Größe, vorgeschlagen worden. Diese bekannten Anordnungen allerdings beschränken den zur Verfügung stehenden Experimentierraum und die Beschickungsöffnung in nachteiliger Weise.

Im Gegensatz dazu erlaubt die erfindungsgemäße Ausgestaltung einen im Vergleich zum Stand der Technik größeren Experimentierraum mit größerer Beschickungsöffnung und damit ein günstigeres Verhältnis zwischen den äußeren Dimensionen des Spulensystems und dem nutzbaren Experimentiervolumen.

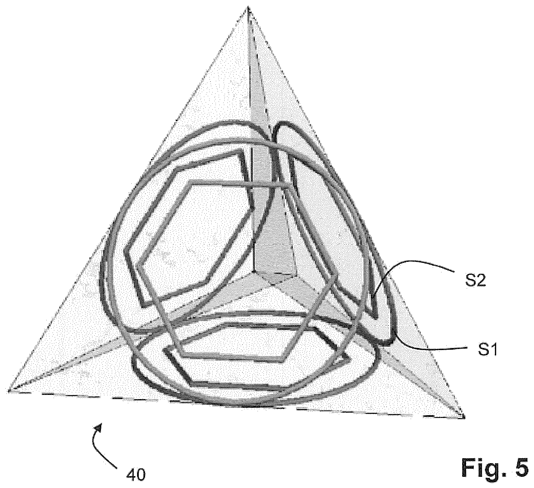

Fig. 5 zeigt eine schematische, räumliche Darstellung eines dreidimensionalen symmetrischen Spulensystems in Tetraederanordnung. Entsprechend den vier Flächen des Tetraeders kann dieser Tetraeder volumenfüllend aus vier identischen erzeugenden Pyramiden aufgebaut werden, deren jeweilige Grundfläche ein gleichseitiges Dreieck bildet. Dieses tetraederförmiges Spulensystem setzt sich somit aus vier identischen Subtetraedern (Dreieckpyramiden) zusammen, innerhalb derer sich jeweils zwei Spulen S1, S2 befinden.

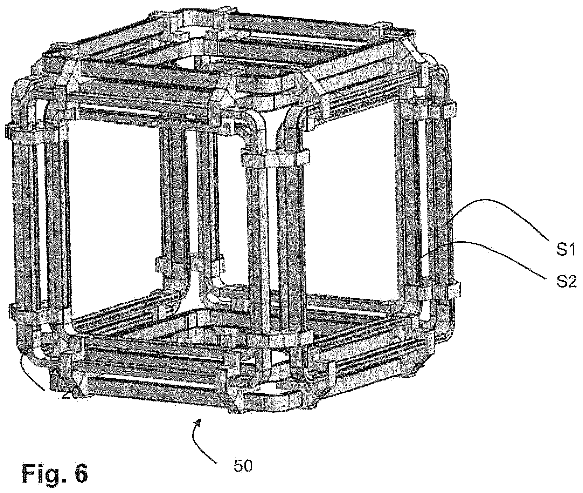

Fig. 6 zeigt ein Modell 50 eines dreidimensionalen symmetrischen Spulensystems in würfelförmiger Anordnung. In diesem Modell sind zwei Spulen S1, S2, die eine erfindungsgemäße Spulenanordnung darstellen, an jeder Würfelseite angeordnet. Die Spulenpaare S1, S2 sind dabei so dimensioniert, dass sie jeweils innerhalb der das Volumen des Würfels ausfüllenden erzeugenden Pyramiden anordenbar sind. Klar erkennbar sind der im Gegensatz zu einer verschachtelten Helmholtz-Anordnung vergrößerte Experimentierraum und dessen gute Zugänglichkeit.

## Patentansprüche

1. Spulensystem (30, 40, 50) zur Erzeugung eines homogenen Magnetfeldes, mit einer Spulenanordnung (2), die jeweils aus mindestens zwei Spulen (S1, S2, S3) besteht, deren jeweilige Windungen (W1, W2, W3) planparallel zueinander liegende, drehsymmetrische Flächen mit unterschiedlicher Größe und einer gemeinsamen, senkrecht auf den Flächen stehenden Drehachse als Spulenachse (4) aufspannen, wobei mindestens eine dieser Spulen (S1, S2, S3) gegensinnig gegenüber einer anderen dieser Spulen von einem Strom durchflossen ist,
**gekennzeichnet durch**
mindestens drei Spulenanordnungen (2), wobei die Spulen (S1, S2, S3) der jeweiligen Spulenanordnung (2) sich innerhalb und planparallel ausgerichtet zur Grundfläche einer erzeugenden Pyramide befinden, deren Spitze mit dem Zentrum eines regelmäßigen, konvexen Polyeders zusammenfällt und deren Grundfläche mit einer solchen Fläche des konvexen Polyeders identisch ist, bei der die Projektion der Pyramidenspitze auf die Pyramidengrundfläche mit dem Mittelpunkt der Pyramidengrundfläche zusammenfällt, wobei der n-flächige Polyeder ein Tetraeder, ein Hexaeder, ein Oktaeder, ein Dodekaeder oder ein Ikosaeder ist, welcher aus n erzeugenden Pyramiden volumenausfüllend zusammensetzbar ist.

2. Spulensystem nach Anspruch 1,
**dadurch gekennzeichnet,**
**dass** die von den jeweiligen Windungen (W1, W2, W3) der jeweiligen Spulen (S1, S2, S3) aufgespannte drehsymmetrische Fläche eine Kombination aus Polygon-Flächensegmenten und Kreis-Flächensegmenten ist.

3. Spulensystem nach Anspruch 1 oder 2,
**dadurch gekennzeichnet,**
**dass** die von den jeweiligen Windungen (W1, W2, W3) einer der Spulen (S1, S2, S3) aufgespannte drehsymmetrische Fläche spiralförmig ausgebildet ist.

4. Spulensystem nach einem der Ansprüche 1 bis 3,
**dadurch gekennzeichnet,**
**dass** ein Windungsverlauf einer der Windungen (W1, W2, W3) abschnittsweise eine Komponente in Richtung der Drehachse aufweist.

5. Verwendung des Spulensystems (30, 40, 50) nach einem der Ansprüche 1 bis 4 in einem System zur Kalibrierung von Magnetfeldsensoren und Magnetkompassen, zur Erzeugung und Simulation magnetischer Randbedingungen an Satelliten und Raumsonden, zur Kompensation magnetischer Felder, zur Reduktion bzw. Neutralisierung magnetischer Signaturen an Schiffskomponenten, zu Tests und Qualitätskontrollen an Permanentmagneten, zur Vermessung magnetischer Eigenschaften in der Materialforschung und Geophysik und zur Erzeugung von Magnetfeldern und Magnetfeldgradienten in der Medizintechnik und Kernspintomographie.

## Claims

1. A coil system (30, 40, 50) for generating a homogeneous magnetic field, the coil system (30, 40, 50) comprising a coil assembly (2), each coil assembly (2) being composed of at least two coils (S1, S2, S3), the respective windings (W1, W2, W3) of said coils (S1, S2, S3) forming plane-parallel, rotationally symmetrical surfaces having different sizes and a common axis of rotation as a coil axis (4) running perpendicular to the surfaces, a current flowing in the opposite direction in relation to another one of said coils through at least one of said coils (S1, S2, S3),
**characterized by**
at least three coil assemblies (2), the coils (S1, S2, S3) of each coil assembly (2) being located inside and oriented plane-parallel to the base surface of a generating pyramid, the apex of which coincides with the center of a regular, convex polyhedron and the base surface of which is identical to a surface of the convex polyhedron in which the projection of the pyramid apex onto the pyramid base surface coincides with the center of the pyramid base surface, wherein the polyhedron having n surfaces is a tetrahedron, a hexahedron, an octahedron, a dodecahedron or an icosahedron which can be composed of n generating pyramids in a volume-filling manner..

2. The coil system according to claim 1,
**characterized in that**
the rotationally symmetrical surface formed by the respective windings (W1, W2, W3) of the respective coils (S1, S2, S3) is a combination of polygonal surface segments and circular surface segments.

3. The coil system according to claim 1 or 2,
**characterized in that**
the rotationally symmetrical surface formed by the respective windings (W1, W2, W3) of one of the coils (S1, S2, S3) is realized in a spiral shape.

4. The coil system according to any one of claims 1 to 3,
**characterized in that**
a winding shape of one of the windings (W1, W2, W3) has, in sections, a component in the direction of the axis of rotation.

5. A use of the coil system (30, 40, 50) according to any one of claims 1 to 4 in a system for calibrating magnetic field sensors and magnetic compasses, for generating and simulating magnetic boundary conditions on satellites and space probes, for compensating magnetic fields, for reducing or neutralizing magnetic signatures on ship components, for testing and controlling the quality of permanent magnets, for measuring magnetic properties in materials research and geophysics and for generating magnetic fields and magnetic field gradients in medical technology and magnetic resonance imaging.

## Revendications

1. Système de bobines (30, 40, 50) pour la génération d'un champ magnétique homogène, le système de bobines (30, 40, 50) comprenant un ensemble de bobines (2), chaque ensemble de bobines (2) étant composé d'au moins deux bobines (S1, S2, S3) dont les enroulements (W1, W2, W3) respectifs forment des surfaces à faces planes et parallèles et à symétrie de rotation qui ont des dimensions différentes et un axe de rotation commun s'étendant perpendiculairement aux surfaces comme axe de bobines (4), au moins une desdites bobines (S1, S2, S3) étant traversée par un courant dans le sens contraire par rapport à une autre desdites bobines,
**caractérisé par**
au moins trois ensembles de bobines (2), les bobines (S1, S2, S3) de l'ensemble de bobines (2) respectif se trouvant à l'intérieur d'une pyramide générant et orientées de manière plan-parallèle par rapport à la surface de base d'une pyramide générant, le sommet de ladite pyramide coïncidant avec le centre d'un polyèdre régulier et convexe et la surface de base de ladite pyramide étant identique à une telle surface du polyèdre convexe dans laquelle la projection du sommet de la pyramide sur la surface de base de la pyramide coïncide avec le centre de la surface de base de la pyramide, dans lequel le polyèdre ayant n surfaces est un tétraèdre, un hexaèdre, un octaèdre, un dodécaèdre ou un icosaèdre qui peut être composé de n pyramides générant de manière à remplir le volume.

2. Système de bobines selon la revendication 1,
**caractérisé en ce que**
la surface à symétrie de rotation formée par les enroulements (W1, W2, W3) respectifs des bobines (S1, S2, S3) respectives est une combinaison de segments de surface d'un polygone et de segments de surface d'un cercle.

3. Système de bobines selon la revendication 1 ou la revendication 2 **caractérisé en ce que**
la surface à symétrie de rotation formée par les enroulements (W1, W2, W3) respectifs d'une des bobines (S1, S2, S3) est réalisée en forme de spirale.

4. Système de bobines selon l'une quelconque des revendications 1 à 3, **caractérisé en ce**
**qu'**un tracé d'un des enroulements (W1, W2, W3) a par sections un composant dans la direction de l'axe de rotation.

5. Utilisation du système de bobines (30, 40, 50) selon l'une quelconque des revendications 1 à 4 dans un système pour l'étalonnage de capteurs de champ magnétique et de compas magnétiques, pour la génération et la simulation de conditions magnétiques aux limites sur des satellites et des sondes spatiales, pour la compensation de champs magnétiques, pour la réduction ou neutralisation de signatures magnétiques sur des composants de navires, pour des tests et des contrôles de qualité sur des aimants permanents, pour la mesure de propriétés magnétiques dans la recherche scientifique sur les matériaux et la géophysique et pour la génération de champs magnétiques et de gradients de champ magnétique dans la technologie médicale et l'imagerie par résonance magnétique.
